# FASCICULE DE BREVET EUROPEEN

(11) **EP 3 059 682 B1**
(45) Date de publication et mention de la délivrance du brevet: **02.10.2024**
(21) Numéro de dépôt: 16156010.7
(22) Date de dépôt: 16.02.2016
(51) Int. Cl.: G06F 17/18, G01D 4/00, G06F 18/40, G06F 18/23

(54) **SYSTEME DE TRAITEMENT DE DONNEES ET DE MODELISATION POUR L'ANALYSE DE LA CONSOMMATION ENERGETIQUE D'UN SITE**
DATENVERARBEITUNGS- UND MODELLIERUNGSSYSTEM FÜR DIE ANALYSE DES ENERGIEVERBRAUCHS EINES STANDORTS
DATA-PROCESSING AND MODELLING SYSTEM FOR ANALYSING THE ENERGY CONSUMPTION OF A SITE

(30) Priorité: 17.02.2015 FR 1551302
(43) Date de publication de la demande: 24.08.2016
(73) Titulaire: Schneider Electric Industries SAS, 92500 Rueil-Malmaison (FR)
(72) Inventeur: MARIE, Sylvain, 38050 Grenoble Cedex (FR); SUARD, Frédéric, 38050 Grenoble Cedex (FR)
(74) Mandataire: Brevalex

(56) Documents cités:
- NAJMEDDINE H ET AL: "Mesures de similarité pour l'aide à l'analyse des données énergétiques de bâtiments", HAL-00656546, VERSION 1, RFIA 2012 (RECONNAISSANCE DE FORMES ET INTELLIGENCE ARTIFICIELLE), 24-27 JANVIER 2012, LYON, FRANCE, January 2012 (2012-01-01), XP055243531, Retrieved from the Internet <URL:https://hal.archives-ouvertes.fr/hal-00656546/document> [retrieved on 20160121]
- ANONYMOUS: "Bibliographic data for hal-00656546, version 1", HAL ARCHIVES-OUVERTES.FR, 21 January 2016 (2016-01-21), XP055243538, Retrieved from the Internet <URL:https://hal.archives-ouvertes.fr/hal-00656546/> [retrieved on 20160121]
- GOUY-PAILLER C ET AL: "Distance and similarity measures for sensors selection in heavily instrumented buildings: application to the INCAS platform", PROCEEDINGS OF THE CIB W78-W102 2011 INTERNATIONAL CONFERENCE, 26-28 OCTOBER 2011, SOPHIA ANTIPOLIS, FRANCE, October 2011 (2011-10-01), XP055243554
- ANONYMOUS: "List of Selected Papers - CIB W078 W102", WEBSITE OF CIB W078-W102 2011 CONFERENCE, 26-28 OCTOBER 2011, SOPHIA-ANTIPOLIS, FRANCE, 21 January 2016 (2016-01-21), XP055243555, Retrieved from the Internet <URL:http://2011-cibw078-w102.cstb.fr/call.html> [retrieved on 20160121]

## Description

### DOMAINE TECHNIQUE ET ART ANTÉRIEUR

La présente invention concerne le domaine du traitement informatique de données de mesures et de la modélisation de ces données pour permettre l'analyse de la consommation énergétique de sites tels que des bâtiments résidentiels, des locaux commerciaux, des usines, des centres de données.

Pour réaliser un audit de consommation énergétique d'un site, outre les relevés de mesure de compteurs électriques, sont apparues des plates-formes équipées de capteurs qui mesurent de nombreux paramètres à différentes positions du site parmi lesquels la température, l'humidité, la pression différentielle, avec des taux d'échantillonnage élevés. D'autre part les plate-formes utilisées dans les systèmes de planification, de contrôle et de supervision de procédés industriels sont également connectées, fournissant de nombreux paramètres parmi lesquels les heures travaillées, les quantités produites.

Cet ensemble est susceptible de produire d'énormes quantités de données à analyser par exemple pour des experts énergétiques.

Il existe un besoin d'un nouvel outil informatique permettant de comprendre rapidement le mode de fonctionnement d'un site en termes de consommation énergétique, de pouvoir analyser son comportement sur une période donnée et en particulier de vérifier si ce site a suivi un mode de fonctionnement attendu, et de modéliser le fonctionnement de ce site pour un futur suivi de ses performances.

Le document H. Najmeddine et al: "Mesures de similarité pour l'aide à l'analyse des données énergétiques de bâtiments", hal-00656546, version 1, RFIA 2012 (Reconnaissance de Formes et Intelligence Artificielle), 24-27 janvier 2012, Lyon, France, janvier 2012 décrit des mesures de similarité qui aident l'analyse énergétique de bâtiments. Des projections utilisant ces mesure visualisent la similarité pour aider l'analyse par un humain.

### EXPOSÉ DE L'INVENTION

L'invention est défini dans les revendications indépendantes 1, 10 et 11. Des modes de réalisation préférées sont exposé dans les revendications dépendantes.

Un mode de réalisation de la présente invention prévoit un procédé de traitement de données pour l'analyse de la consommation énergétique d'au moins un site à partir de données de mesures, parmi lesquelles des données de mesures de consommation électrique ainsi que des données de mesures d'un ou plusieurs paramètres physiques, issues d'au moins un dispositif de mesure disposé sur ce site, le procédé comprenant des étapes consistant à, par le biais d'un système de traitement informatique :
a) sélectionner, dans un plage temporelle d'analyse choisie, des séries temporelles de données issues du dispositif de mesure, les séries temporelles de données étant associées à des métadonnées explicatives desdites séries temporelles de données,
b) segmenter les séries temporelles de données en une pluralité de tronçons de données d'une même durée,
c) effectuer une projection des tronçons de données sélectionnés et situés dans cette plage temporelle d'analyse dans un espace à au moins deux dimensions en fonction de leur degré de similarité,
d) afficher dans une interface graphique logicielle par le biais d'un dispositif d'affichage relié au système de traitement informatique, une représentation graphique dudit espace comportant des projections des tronçons de données, certaines projections étant regroupées sous forme d'un ou plusieurs groupes de tronçons de données.

Le dispositif de mesure est doté d'un ou plusieurs éléments de mesure(s) dont au moins un compteur de consommation électrique et/ou un ou plusieurs capteurs de mesure de grandeurs physique(s).

La création des groupes de tronçons peut être établie automatiquement au moyen d'un algorithme de classification non supervisée, par exemple par partitionnement, avec des méthodes de type méthode des centres mobiles (k-means), partitionnement autour des médoïdes (PAM, k-medoïds), CLARA (acronyme de « Clustering LARge Application »), méthode des nuées dynamiques, méthode de classification floue (FANNY), ou DBSCAN (acronyme de « Density-Based Spatial Clustering of Applications with Noise ») ; ou par exemple par classification hiérarchique, avec des méthodes de type classification ascendante hiérarchique (AGNES, acronyme de « agglomerative nesting »), ou classification descendante hiérarchique (DIANA, acronyme de « divisive analyzing »).

Une telle représentation graphique permet de faciliter la sélection de données et la discrimination de données aberrantes.

Ensuite, le traitement comporte des étapes consistant à :
e) sélectionner au moins un premier groupe de tronçons de données,
f) établir un ou plusieurs modèle numériques caractérisant le premier groupe de tronçons de données sélectionné.

De tels modèles peuvent permettre dans une étape ultérieure après acquisition de nouvelles données, de suivre les performances du site et détectent d'éventuelles anomalies de consommation sur un site.

Parmi les modèles établis à l'étape f) figure un modèle numérique individuel caractérisant l'appartenance des tronçons de données à un premier groupe, construit à partir d'une analyse de profils temporels de mesure contenus dans les tronçons de données de ce premier groupe. Ce modèle peut être linéaire, linéaire par morceaux ou non linéaire, et par exemple basé sur des seuils de détection, une machine à vecteur de support à une classe ou une analyse en composante principale à noyaux.

Parmi les modèles établis à l'étape f) figure également un modèle numérique individuel calendaire donnant une condition d'appartenance de nouvelles données à un groupe de données à partir de métadonnées temporelles associées auxdites nouvelles données.

Après l'étape f), on effectue des étapes consistant à :
- faire l'acquisition de nouvelles données,
- utiliser le modèle numérique individuel caractéristique pour vérifier l'appartenance des nouvelles données à un groupe de données.

Parmi les modèles établis à l'étape f) figure un modèle de régression apte à fournir une estimation des données de mesures d'au moins un élément sélectionné du dispositif de mesure à partir de données issues d'un ou plusieurs autres éléments de mesure(s) du dispositif de mesure.

Par exemple ce modèle peut être linéaire, linéaire par morceaux ou non linéaire, basé sur une méthode de moindre carrés ou une machine à vecteurs de support ou une machine à vecteurs de pertinence.

Selon une possibilité de mise en oeuvre, le procédé peut comprendre des étapes consistant à :
- établir pour le premier groupe un profil type de grandeur(s) mesurée(s) par le dispositif de mesure pour une durée correspondant à celle des tronçons, puis
- afficher ce profil type par le biais de l'interface graphique.

Le procédé peut comprendre des étapes consistant à :
- sélectionner, par le biais de l'interface graphique logicielle, un groupe particulier de tronçons de données,
- associer ce groupe particulier à un identifiant.

L'identifiant peut être produit à l'aide d'un algorithme de nommage implémentant un arbre de décision et utilisant des métadonnées associées aux tronçons de données du groupe particulier.

La sélection des séries temporelles de données à l'étape a) peut comprendre une sélection d'au moins un type de métadonnée, en particulier :
- d'un descripteur de zone du site pour sélectionner des séries temporelles de données de mesures issues d'une ou plusieurs zones particulières du site parmi un ensemble de zones du site,
- et/ou d'un descripteur de type de dispositif de mesure pour sélectionner des séries temporelles de données issues d'un ou plusieurs types de moyens de mesure particuliers parmi un ensemble de moyens de mesures du dispositif de mesure,
- et/ou d'un descripteur de type de paramètre de mesure du site pour sélectionner des séries temporelles de données relatives à un ou plusieurs types de paramètres physiques parmi un ensemble paramètres physiques que le dispositif de mesure est susceptible de mesurer.

Le procédé comprend en outre une sélection, par le biais de l'interface graphique logicielle et parmi lesdites projections de tronçons d'une ou plusieurs projections particulières qui n'appartient à aucun groupe.

La représentation graphique obtenue à l'étape d) peut être située dans une première fenêtre de l'interface graphique logicielle et dans lequel les tronçons sont en outre représentés sous une autre forme dans une deuxième fenêtre de l'interface graphique, la sélection du premier groupe dans ladite première fenêtre entrainant une sélection et une mise en évidence dans ladite deuxième fenêtre des tronçons du premier groupe.

La sélection des séries temporelles de données effectuée à l'étape a) ou la sélection du premier groupe effectuée à l'étape e), peut être réalisée par le biais de cette autre représentation graphique.

Le degré de similarité à l'étape c) peut être établi en sélectionnant une métrique.

Cette métrique peut être sélectionnée par le biais de l'interface graphique logicielle parmi une liste de plusieurs métriques différentes.

Une sélection d'un algorithme de projection peut accompagner la sélection de cette métrique.

Cette sélection peut être également effectuée par le biais de l'interface graphique logicielle parmi une liste de plusieurs algorithmes de projection différents

Une sélection d'un algorithme de classification non supervisée peut accompagner la sélection de cette métrique et de cet algorithme de projection.

Cette sélection peut être également effectuée par le biais de l'interface graphique logicielle parmi une liste de plusieurs algorithmes de classification non supervisée différents.

Le procédé de traitement de données comprend en outre des étapes consistant à :
- recevoir de nouvelles données,
- détecter à l'aide d'un modèle calendaire, à partir des métadonnées temporelles associées à ces nouvelles données, si ces nouvelles données appartiennent à un groupe particulier parmi lesdits groupes,
- vérifier l'appartenance de ces nouvelles données au groupe particulier à l'aide d'un modèle individuel caractéristique associé au groupe particulier,
- utilisation d'un modèle de régression pour obtenir une valeur de consommation énergétique nominale,
- comparer la valeur de consommation nominale aux nouvelles données.

Un mode de réalisation de la présente invention prévoit un programme d'ordinateur comprenant des instructions de code de programme pour permettre au système de traitements informatique d'exécuter une ou plusieurs des étapes du procédé tel que défini plus haut.

Un mode de réalisation de la présente invention prévoit également un support de données numériques utilisable par un système de traitement informatique, comprenant des instructions de code d'un programme d'ordinateur tel que visé plus haut.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente schématiquement un système informatique comprenant une plateforme expert dotée d'un outil d'analyse et de modélisation de données objet d'un mode de réalisation de la présente invention et qui permet l'analyse de la consommation énergétique de sites à partir de données de mesures effectuées sur ces sites ;
- la figure 2 représente un exemple d'organigramme reprenant une première séquence d'étapes de traitement susceptibles d'être mises en oeuvre par l'outil d'analyse et de modélisation de données ;
- la figure 3 représente un exemple d'organigramme reprenant une deuxième séquence d'étapes de traitement susceptibles d'être mises en oeuvre par l'outil d'analyse et de modélisation de données ;
- Les figures 4A-4H illustrent un tableau de bord d'un exemple d'interface graphique de l'outil d'analyse et de modélisation de données ;
- les figures 5A-5B illustrent des groupes de données projetées et leur association à un identifiant à l'aide d'un arbre de décision par l'outil d'analyse et de modélisation de données ;
- la figure 6 représente un profil type d'énergie électrique consommée en fonction de la température susceptible d'être obtenu et affiché à l'aide de l'outil d'analyse et de modélisation de données ;
- la figure 7 représente un exemple de traitement effectué par un système de suivi de performances configuré utilisant un ou plusieurs modèles de référence fourni par l'outil d'analyse et de modélisation de données suivant l'invention ;

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

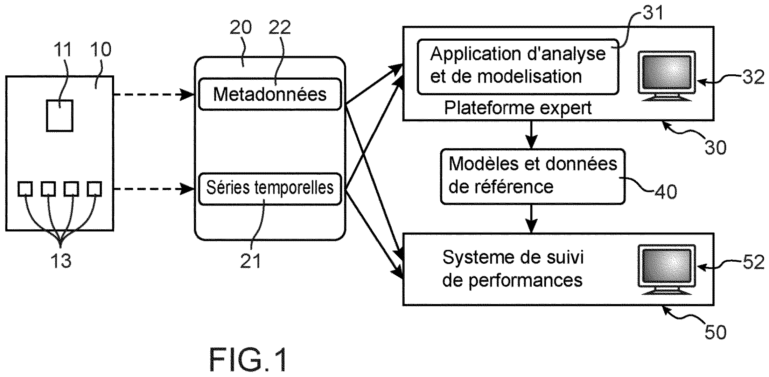

Un exemple de système de traitement de données pour l'analyse du comportement énergétique d'un site sur une plage temporelle déterminée est illustré sur la figure 1.

Le site étudié peut être par exemple un bâtiment ou une usine ou un local commercial ou un centre de données dont on souhaite faire un audit de consommation énergétique. Ce site est équipé d'au moins un dispositif de mesure 10 produisant des données à traiter.

Le dispositif de mesure 10 peut être doté d'un ou plusieurs éléments de mesure(s) notamment d'au moins un compteur 11 de consommation électrique ainsi que d'un ou plusieurs capteurs 13 de mesures, en particulier des capteurs de mesure de grandeurs physiques telles que par exemple la température, le taux d'humidité, la pression différentielle, la vitesse de l'air. Le dispositif de mesure 10 est susceptible de fournir une quantité importante de données à analyser. Certains capteurs peuvent en effet fournir des données selon une fréquence de l'ordre d'au moins une mesure par minute.

Parmi les données 21 à traiter issues du dispositif de mesure 10 figurent des séries temporelles de données 21. Ces séries temporelles peuvent être des séquences de paires temps/valeur de mesures.

Les séries temporelles sont accompagnées de métadonnées 22, c'est-à-dire de données explicatives des séries temporelles. Parmi ces métadonnées 22 on peut distinguer des métadonnées d'un premier type que l'on appelle « séries » et qui regroupent des premiers descripteurs des séries temporelles. Un exemple de métadonnée série : [Bâtiment=Site_38TEC, Zone=Bureau, Type=Energie, Capteur=PM200] indique une zone particulière du bâtiment qui est étudiée, ainsi que le type de donnée de mesure étudié et le type de capteur dont est issue cette donnée de mesure. Des métadonnées d'un deuxième type appelé « temporelles » accompagnent également les séries temporelles de données. Les métadonnées temporelles sont des descripteurs d'un temps. Par exemple, une date « 18/02/14 00:00 » peut être décrite avec la métadonnée temporelle suivante : [année=2014, mois=février, jour=18, jour de la semaine=mardi, trimestre=1, semestre=1].

L'analyse des données de mesure est réalisée par le biais d'une application 31, objet de la présente invention, plus particulièrement d'un logiciel d'analyse et de modélisation qui peut être installé sur une plateforme 30 informatique appelée « plateforme expert ». La plateforme 30 expert peut être centralisée ou en variante distribuée sur plusieurs équipements informatiques.

L'application 31 peut être éventuellement accessible par un système informatique de type « cloud computing » (en français informatique en nuage). L'application 31 d'analyse et de modélisation comprend notamment un outil d'analyse visuelle permettant une exploration visuelle et interactive ainsi qu'une représentation graphique des données de mesure importées.

L'application 31 d'analyse et de modélisation permet d'effectuer une recherche de groupes de données ayant des profils temporels similaires, et ce même pour un volume de données important.

L'application 31 d'analyse et de modélisation peut être commandée par un utilisateur et/ou au moins un script informatique. Dans les deux cas, le traitement de données effectué par l'application 31 permet l'établissement d'un ou plusieurs modèles numériques de comportement énergétique du site étudié dans une plage temporelle déterminée.

Les modèles produits par l'application 31 d'analyse peuvent être intégrés dans des fichiers informatiques utilisables par des applications de bureautique.

Ces fichiers peuvent être par exemple sous une première forme appelée « rapport » ou une deuxième forme appelée « projet » et permettent de faciliter la compréhension, le profilage du comportement énergétique du site ainsi que la réalisation d'analyses comparatives.

Un exemple de modèle numérique donne la consommation électrique en fonction de la température moyenne dans le site pour une période donnée, par exemple journalière. Des représentations graphiques de tels modèles sont visualisables par le biais d'une interface graphique de l'application 31.

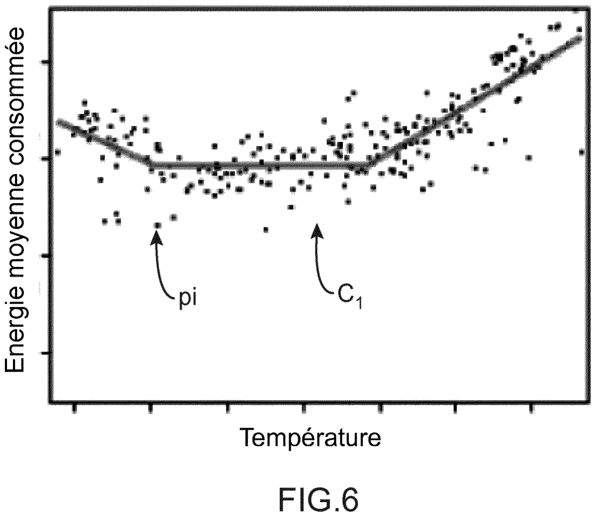

A titre d'exemple, la figure 6 donne une représentation graphique C₁ obtenue à l'aide de l'application 31 du modèle de l'énergie moyenne consommée d'un site en fonction de la température. L'application 31 permet une meilleur discrimination des points de mesure Pi grâce à la création et au nommage des groupes, et d'isoler plus aisément des points de mesure aberrants : ici seul le groupe « jour ouvrés non aberrants » a été conservé ce qui a permis la construction d'un modèle numérique performant.

Ainsi, outre la mise en oeuvre de modèles numériques, l'application 31 permet à un utilisateur de réaliser une analyse visuelle des données de mesure par le biais de l'interface graphique. L'application 31 permet également d'extraire et/ou d'identifier des groupes de données relevant de situations similaires puis éventuellement d'associer ces groupes à un identifiant généré à l'aide d'un algorithme de nommage, et de produire un modèle numérique de comportement du groupe.

Par exemple, dans le cas où le site étudié est un local commercial, un groupe de données de mesures effectuées les jours non-ouvrés et les jours fériés peut être créé et étudié afin de le comparer avec un autre groupe de données de mesures effectuées les jours ouvrés.

L'application 31 peut comprendre outre un outil d'analyse, un outil de requêtage permettant de rechercher, extraire, trier et mettre en forme des données.

L'application 31 peut également comprendre des bibliothèques d'interface d'utilisateur, des bibliothèques graphiques, des bibliothèques de gestion et transformation de données en mémoire, des bibliothèques de génération de données à partir de modèles, un outil de stockage et de gestion de données, un outil de stockage et de gestion de modèles, un outil de stockage et de gestion de projets.

Les modèles 40 et données produits par la plateforme expert 30 peuvent ensuite être exploités par un système 50 informatique de suivi de performances de sites. Un tel système 50 est également susceptible de recevoir des données en provenance du dispositif de mesure 10. Le système 50 de suivi de performances est configuré pour effectuer une comparaison entre un modèle ou un ensemble de modèles de référence fourni(s) par l'application 31 de la plateforme expert 30 et le comportement réel du site donné en temps réel et en continu par le biais de données issues du dispositif de mesure 10. Ce système 50 de suivi de performances peut être centralisé ou en variante distribué sur plusieurs équipements informatiques 52 sur lesquels des applications développées par la demanderesse telle que « Energy Operation First » ou « Facility Insight », « StruxureWare Plant Operation Ampla », « StruxureWare Resource Advisor », « Remote Energy Management » peuvent être également déployées et permettent en se servant de modèles produits par la plateforme 30 de réaliser une prédiction, par exemple celle d'un prochain pic de consommation et de son coût, ou de détecter un dysfonctionnement, par exemple une surconsommation électrique anormale, ou d'effectuer une comparaison avec d'autres sites afin de définir des leviers d'améliorations de performances énergétiques du site étudié.

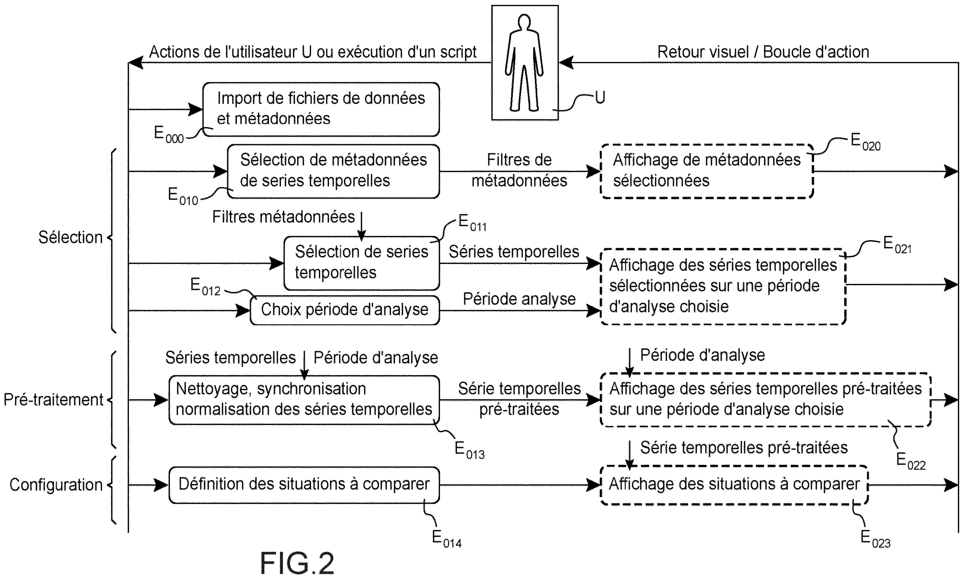

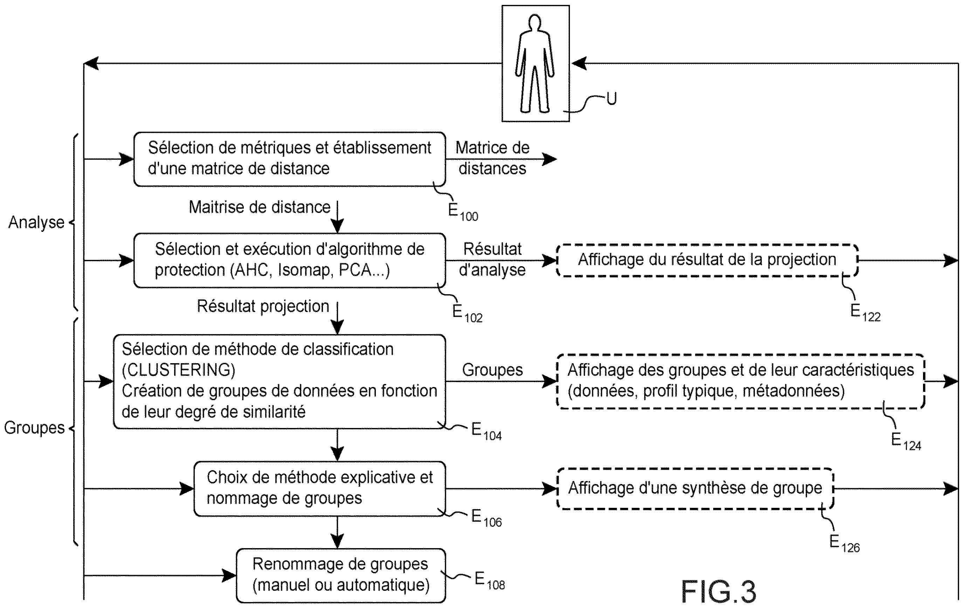

Les figures 2 et 3 illustrent des phases de traitement de données comprenant des étapes encore appelées « actions » susceptibles d'être réalisées par l'application 31 d'analyse et de modélisation. Sur ces figures, chaque action (représentée par un cadre en trait continu) de configuration ou d'exécution d'algorithme produit un résultat (représenté par une flèche issue du cadre en trait continu), qui peut être utilisé pour créer ou mettre à jour une ou plusieurs vues graphiques interactives affichées (l'action d'affichage étant représentée par un cadre en trait discontinu) sur un écran, en particulier d'un équipement informatique de la plateforme 30.

La mise en oeuvre de certaines actions, la création ou la mise à jour des vues graphiques interactives peut dans certains cas être conditionnée par la réception préalable de résultats (représentés par des flèches disposées au-dessus des cadres) de traitement ou d'une saisie par l'utilisateur.

Dans le cas où un utilisateur humain commande l'application 31, les vues graphiques interactives aident celui-ci dans son analyse des données issues du site et lui permettent de choisir une prochaine action ou d'établir un diagnostic sur la consommation énergétique du site.

Préalablement à une phase de traitement de données permettant l'établissement de modèles, une phase dite « amont » illustrée sur l'organigramme séquentiel de la figure 2 est mise en oeuvre par l'application 31.

Durant cette phase amont, des actions de sélection, de prétraitement, et de configuration sous la commande de l'utilisateur U ou d'un script informatique sont réalisées.

Un import (étape Eooo sur la figure 2) des séries temporelles et de leurs métadonnées vers la plateforme expert 30 peut être effectué avant cette phase amont.

Les données et métadonnées importées peuvent provenir par exemple :
- d'un ou plusieurs équipements informatiques de gestion à distance, tels que ceux de type SCADA (pour « Supervisory Control and Data Acquisition ») et/ou,
- d'une plate-forme de contrôle continu raccordée au dispositif de mesure 10 du site étudié et/ou,
- d'un système dédié de collecte de données et des métadonnées.

L'étape d'import est facultative lorsque les données et métadonnées à traiter sont sous forme d'un ou plusieurs fichiers pré-enregistrés dans la plateforme 30.

Ensuite, la sélection de séries de données à analyser est effectuée. Cette sélection peut être réalisée directement (étape E₀₁₁) ou par l'intermédiaire d'une sélection des métadonnées particulières (étape E₀₁₀) et peut être ensuite affichée (étapes E₀₂₀ et E₀₂₁).

Cette sélection est également accompagnée d'une sélection d'une plage temporelle d'analyse (étape E₀₁₂) sur laquelle on souhaite concentrer l'analyse. Cette plage temporelle peut être continue, par exemple sur une année ou sur un semestre, ou sur un mois ou une semaine. En variante, cette plage temporelle peut présenter des discontinuités. On peut par exemple sélectionner tous les jours ouvrés d'une année ou toutes les heures ouvrées d'une journée. Un autre exemple de sélection de plage discontinue regroupe des données du site prises du lundi au jeudi pour toutes les semaines d'une année.

Par ailleurs, un décompte d'un taux de données manquantes sur une plage temporelle donnée sélectionnée, par exemple sur un jour, peut être déterminée par l'application 31 et affichée. Cela peut permettre d'aider l'utilisateur à réaliser son choix de la plage temporelle d'étude.

Après cette sélection, une étape de pré-traitement (étape E₀₁₂) est réalisée. Ce pré-traitement peut comprendre une sous-étape de nettoyage, afin notamment de supprimer des données aberrantes. Par exemple, des données de mesure situées en dehors d'une plage de travail dans laquelle les capteurs du dispositif de mesure 10 sont censés opérer peuvent être supprimées lors d'une telle étape.

Le pré-traitement peut également comprendre une synchronisation ou re-synchronisation des séries temporelles sur un pas d'échantillonnage fixe choisi par l'utilisateur. Cette synchronisation peut être réalisée par interpolation. Le pas d'échantillonnage fixe peut être par exemple de 1 minute, ou de 10 minutes, ou de 1 heure, ou de 1 jour. Cette étape peut être utile notamment lorsque l'échantillonnage des données de mesure est irrégulier.

Le pré-traitement peut également comprendre une sous-étape de normalisation des séries temporelles durant laquelle un changement d'échelle peut être notamment opéré. Le résultat de l'étape de prétraitement peut être ensuite affiché (étape E₀₂₂).

La phase « amont » comprend en outre une étape supplémentaire (étape E₀₁₄) durant laquelle une métadonnée temporelle est sélectionnée, les séries temporelles sélectionnées étant alors segmentées en tronçons d'une même durée. On peut par exemple réaliser une segmentation des séries temporelles de données en tronçons d'un mois ou d'une semaine, ou de préférence d'un jour. Cette étape de segmentation permet de définir des situations à comparer.

La segmentation peut également comprendre une sélection d'une métadonnée série particulière.

On peut sélectionner par exemple un descripteur de zone du site pour sélectionner uniquement des données relatives à une ou plusieurs zones particulières du site parmi l'ensemble de zones couvertes par le dispositif de mesure 10. Une comparaison de consommation énergétique de zones du site peut être ainsi mise en oeuvre.

On peut également sélectionner par exemple un descripteur de type de capteur de mesure pour sélectionner uniquement des données issues d'un ou plusieurs capteurs particuliers du dispositif de mesure 10. Une telle sélection permet de réaliser une comparaison entre des données issues d'un premier groupe de capteurs par rapport à des données issues d'un deuxième groupe de capteurs.

Selon un autre exemple, on peut également sélectionner un descripteur de type de paramètre de mesure pour sélectionner uniquement des données relatives à un ou plusieurs types de paramètres physiques particuliers parmi l'ensemble des paramètres physiques mesurés par le dispositif de mesure 10.

Après la phase amont, une phase de traitement dite d'« analyse », conduisant à une projection des tronçons de données et une phase de traitement dite « de groupes » permettant de former des groupes de tronçons de données projetées présentant des similitudes est effectuée.

Sur la figure 3, un exemple d'organigramme d'étapes effectuées lors d'une telle phase d'analyse est donné.

Pour pouvoir effectuer une mesure de similarité entre des tronçons de données, une matrice de distances est tout d'abord établie (Etape E₁₀₀ sur l'organigramme séquentiel de la figure 3).

Pour cela, préalablement à cette étape, une sélection de métrique parmi une liste de métriques pré-enregistrées peut être réalisée. Une métrique est une fonction qui définit la distance entre les éléments d'un ensemble. La métrique sélectionnée peut être par exemple de type distance Euclidienne, ou par exemple de type DTW (pour « Dynamic Time Warping ») ou de type CID pour (« complexity invariance distance ») ou de type distance de Manhattan ou bien de type DcorT et telle que présentée par exemple dans le document de Ahlmane Douzal-Choukria et Cécile Amblard : « Classification trees for time series », Pattern Recognition journal, vol. 2, n°45, p. 1076-1091, 2011.

Une métrique configurée ou importée par l'utilisateur U lui-même peut également être sélectionnée et utilisée. Ainsi, l'application 31 peut également comprendre un outil permettant à l'utilisateur U de définir lui-même une métrique différente de celles qui sont pré-enregistrées.

Une fois la matrice de distances établie par l'application 31, un algorithme de projection est exécuté (Etape E₁₀₂) afin de projeter les tronçons de séries temporelles dans un espace à au moins deux dimensions en fonction de leur degré de similarité. L'algorithme de projection peut être également sélectionné au préalable par l'utilisateur U parmi une pluralité d'algorithmes de projections. L'algorithme de projection peut être par exemple un algorithme de type ISOMAP ou de type groupement hiérarchique (en anglais « hierarchical clustering ») ou de type Analyse en composantes principales (également désigné sous l'acronyme ACP).

Le résultat de cette projection peut être ensuite affiché (étape E₁₂₂) par le biais de l'interface graphique logicielle de l'application 31.

La sélection de métrique, l'import de métrique, la sélection d'algorithme de projection peuvent être réalisées par l'utilisateur U à l'aide par exemple de menus déroulants d'une fenêtre de commande de l'interface graphique. Cette fenêtre de commande peut être éventuellement celle à partir de laquelle un import de données et une sélection de plage temporelle d'étude peuvent être réalisés.

Ensuite, une classification des données (étape E₁₀₄) encore appelée « clustering » est effectuée. Cette étape peut comprendre une sélection d'un algorithme de classification non supervisée, et conduit par exécution de cet algorithme à la formation ou la mise en évidence de groupes de données projetées similaires, et à la mise en évidence ou à la discrimination de données aberrantes. Pour effectuer cette classification, un algorithme de partitionnement de type méthode des centres mobiles (k-means), partitionnement autour des médoides (PAM, k-medoïds), CLARA (acronyme de « Clustering LARge Application »), méthode des nuées dynamiques, méthode de classification floue (FANNY), ou DBSCAN (acronyme de « Density-Based Spatial Clustering of Applications with Noise ») ; ou un algorithme de classification hiérarchique de type classification ascendante hiérarchique (AGNES, acronyme de « agglomerative nesting »), ou classification descendante hiérarchique (DIANA, acronyme de « divisive analyzing ») peut être employé.

Cette classification peut être réalisée à partir du résultat de l'étape de projection ou selon une variante (non représentée sur la figure 3) peut être couplée à l'étape de projection.

Outre cette classification « automatique » en groupe de données, une classification « manuelle » mise en oeuvre par l'utilisateur peut être également effectuée, par exemple à partir d'une vue sur laquelle les données projetées sont affichées.

Un affichage (étape E₁₂₄) des groupes et de leurs caractéristiques associées par exemple d'un profil typique, de métadonnées associées, peut être réalisé à l'aide de différentes vues interactives.

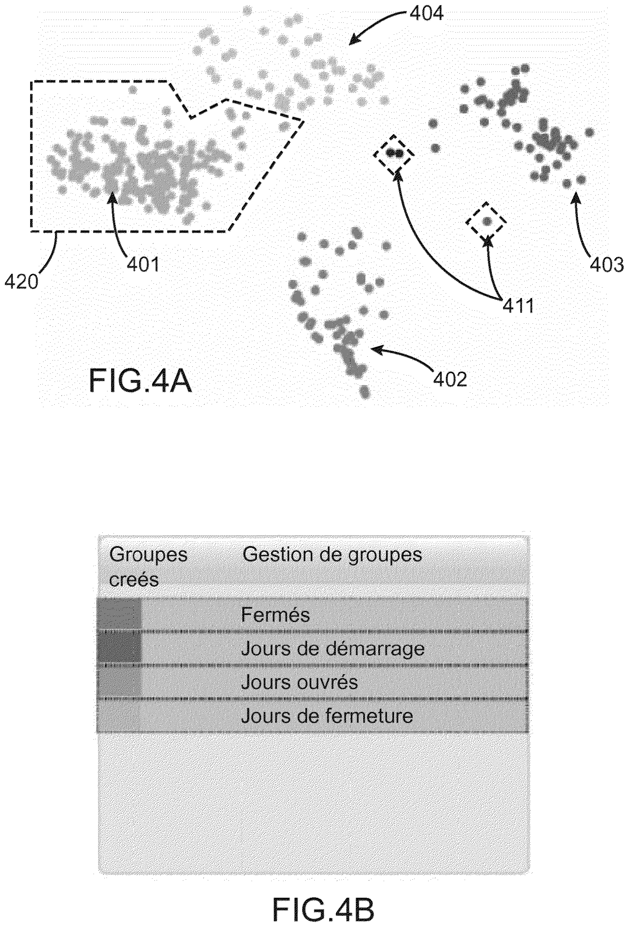

Des exemples de telles vues interactives sont données sur les figures 4A-4H.

On peut associer ensuite à chaque groupe de données un identifiant.

Un nommage des groupes peut pour cela être réalisé par l'utilisateur de manière « manuelle », à partir de sa compréhension du groupe apportée par exemple par les différentes vues interactives sur lesquelles ces groupes et leurs caractéristiques associées sont représentées.

Un nommage automatique des groupes, ou une aide au nommage manuel, peuvent être également prévus (étape E₁₀₆) à l'aide d'un algorithme utilisant un arbre de décision exécuté sur les métadonnées associées à ces groupes.

En variante, l'association d'un groupe de données à un identifiant est réalisé de manière semi-automatique. Dans ce cas, l'application 31 propose un identifiant pour un groupe de données établi en fonction des similitudes détectées.

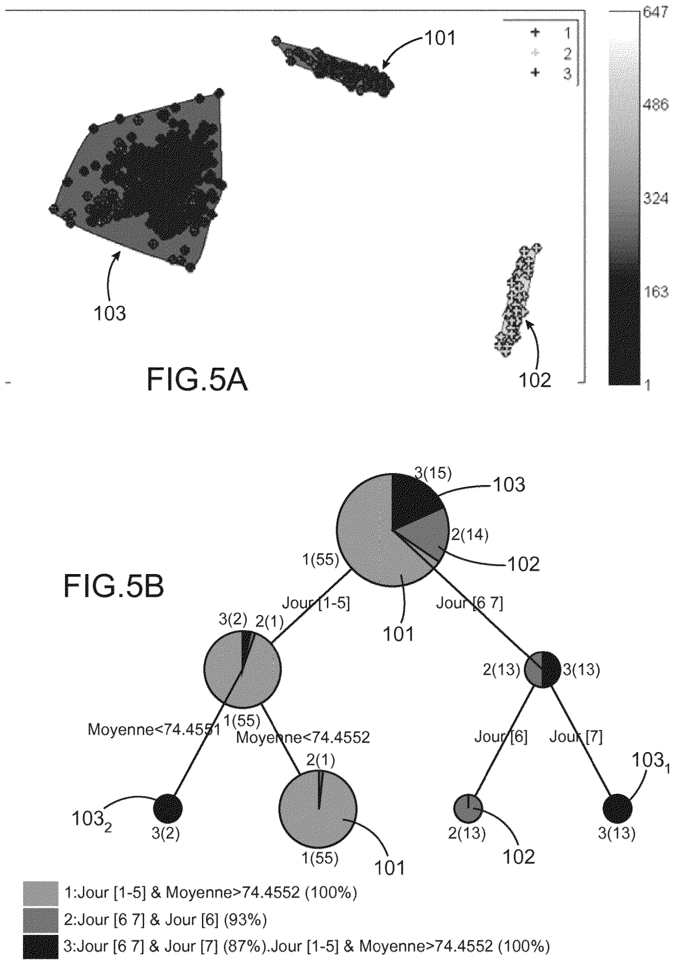

Sur la figure 5B, un exemple d'arbre de décision ayant permis de nommer trois groupes 101, 102, 103 de données identifiés est donné.

Les groupes correspondants sont représentés sur une vue illustrée sur la figure 5A.

Dans cet exemple, les séries temporelles ont été segmentées en tronçons de durée égale à un jour. L'algorithme de nommage utilisant l'arbre de décision identifie un premier groupe 101 de données ayant des similitudes sur plusieurs critères puisque l'essentiel des données du premier groupe correspondent à des données prélevées lors de l'un des 5 premiers jours de la semaine et à des données sur un jour de mesure d'un paramètre supérieur ou égal en moyenne à un seuil donné.

Un deuxième groupe 102 de données est également identifié.

Dans cet exemple, l'essentiel des données du deuxième groupe correspond à des données prélevées lors du 6^{ème} ou 7^{ème} jour de la semaine.

Un troisième groupe 103 de données est également identifié. Le troisième groupe de données 103 comprend un sous-groupe 103₁ de données prélevées lors de l'un des 5 premiers jours de la semaine et correspondant à une mesure d'un paramètre inférieur à un seuil donné. Le troisième groupe de données 103 comprend un autre sous-groupe 103₂ de données prélevées lors du 6^{ème} ou 7^{ème} jour de la semaine.

L'algorithme nomme par exemple le premier groupe de données « jour [1-5] et moy >= 75 ».

En plus de permettre d'aider au nommage de groupes de données projetées, l'algorithme de nommage et son arbre de décision associé permettent ainsi de mettre en évidence pour l'utilisateur des critères d'appartenance à un groupe de données.

L'utilisateur peut ensuite éventuellement re-nommer un groupe en fonction de sa compréhension de celui-ci.

Une étape (étape E₁₂₆) d'affichage d'une synthèse graphique résumant les caractéristiques de la totalité ou d'un sous-ensemble des groupes de données peut être ensuite effectuée.

La vue sur laquelle les projections de tronçons de données sont représentées peut être une fenêtre de tableau de bord telle qu'illustrée sur la figure 4A.

Sur cette fenêtre, quatre amas correspondant à quatre groupes 401, 402, 403, 404, de tronçons de données projetées distingués par des couleurs différentes (sur la figure 4A les couleurs étant remplacées par des niveaux de gris) sont représentés.

Une sélection de tronçon(s) ou d'un groupe ou d'un sous-groupe est effectuée par l'utilisateur à l'aide d'un outil graphique de sélection 420 apparaissant par exemple sous forme d'un polygone ou d'un lasso de sélection.

La sélection de tronçon(s) dans la fenêtre de la figure 4A peut entraîner une sélection de ces mêmes tronçon(s) sur d'autres fenêtres du tableau de bord et réciproquement. L'utilisateur U peut ainsi naviguer dans la masse de données à l'aide d'une pluralité de fenêtres donnant des vues complémentaires de celle de la projection illustrée sur la figure 4A. Des tronçons particuliers 411 situés à une distance donnée des amas peuvent constituer des valeurs aberrantes à éliminer que l'utilisateur U peut sélectionner puis éventuellement supprimer.

Comme indiqué plus haut, les tronçons respectifs des groupes de données 401, 402, 403, 404 peuvent être associés à un identifiant.

Dans une autre fenêtre du tableau de bord donnée sur la figure 4B, les tronçons de données appartenant au premier groupe 401 sont identifiées comme « jours ouvrés ». Les tronçons du premier groupe 401 peuvent correspondre par exemple à des jours pendant lesquels le site est en fonctionnement de sorte que sa consommation électrique est supérieure à un seuil donné et est sensiblement constante sur un intervalle de temps donné de la journée.

Les tronçons appartenant à un deuxième groupe 402 sont identifiés comme « jours fermés ». Les tronçons du deuxième groupe peuvent correspondre à des jours pendant lesquels le site n'est pas en fonctionnement de sorte à générer par exemple une consommation électrique inférieure à un seuil donné et qui est sensiblement constante sur l'intervalle de temps précité.

Les tronçons appartenant à un troisième groupe 403 sont identifiés par exemple comme « jours de démarrage » et correspondent à des jours pendant lesquels le site n'est en fonctionnement que sur une partie de la journée.

Les tronçons appartenant à un quatrième groupe 404 sont identifiés par exemple comme « jours de fermeture » et correspondent à des jours pendant lesquels le site n'est en fonctionnement que sur une partie de la journée.

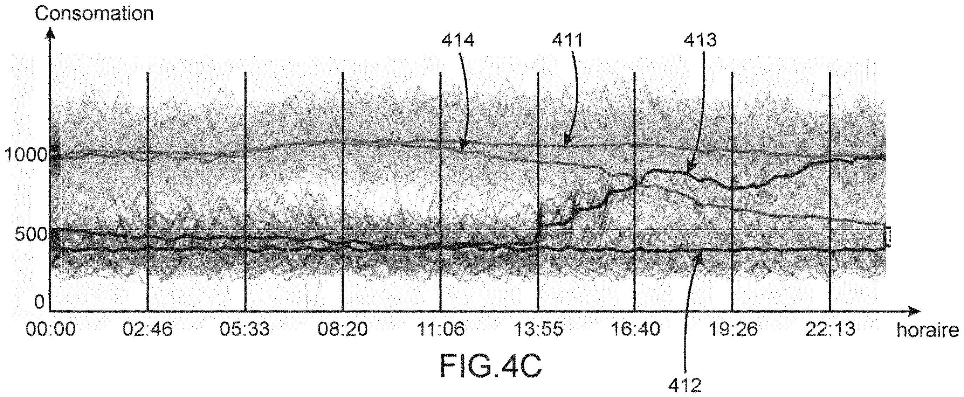

Une autre fenêtre du tableau de bord illustrée sur la figure 4C et donne une consommation énergétique du site, en particulier sa consommation électrique, sur une durée correspondant à celle selon laquelle la segmentation des séries temporelles de données a été réalisée précédemment.

Dans l'exemple de la figure 4C, les courbes 411, 412, 413, 414 sont représentatives de profils type de consommation électrique durant une journée, respectivement pour des données issues du premier groupe 401, pour des données issues du deuxième groupe 402, pour des données issues du troisième groupe 403, et pour des données issues du quatrième groupe 404.

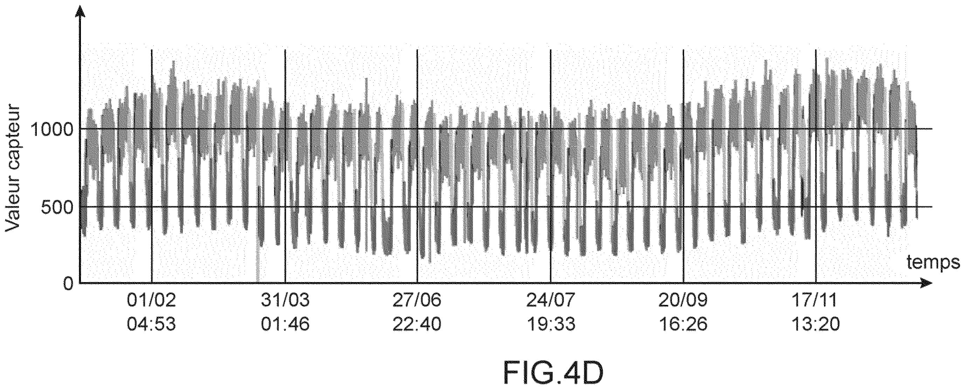

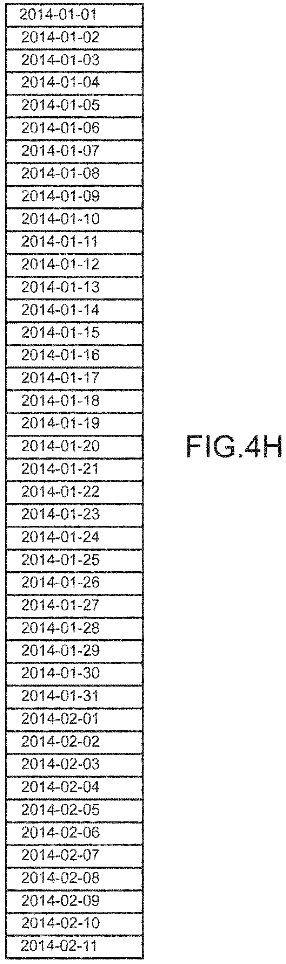

Sur une autre fenêtre de tableau de bord donnée sur la figure 4D, des données de mesure issues de capteurs du dispositif de mesure 10 sont représentées pour une plage temporelle d'analyse sélectionnée par exemple à l'aide de la fenêtre de la figure 4H répertoriant les dates auxquelles les mesures ont été effectuées.

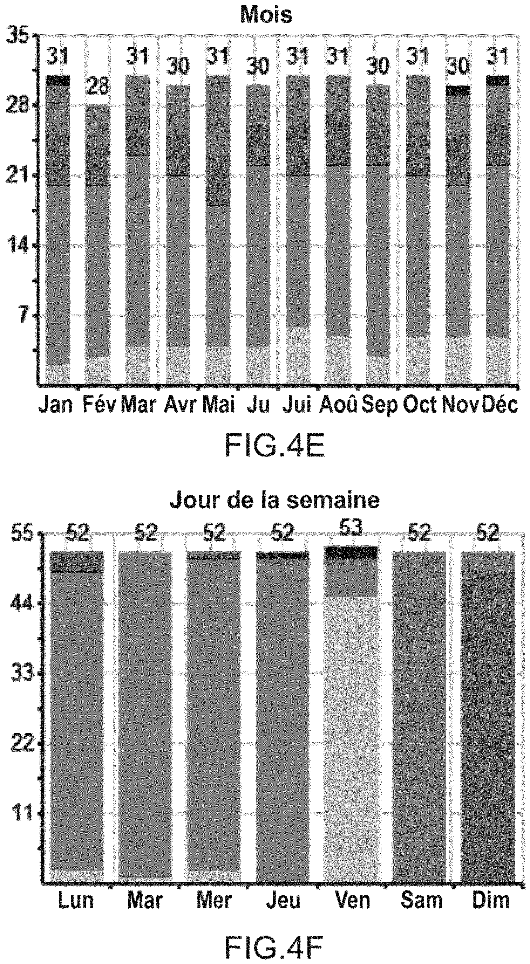

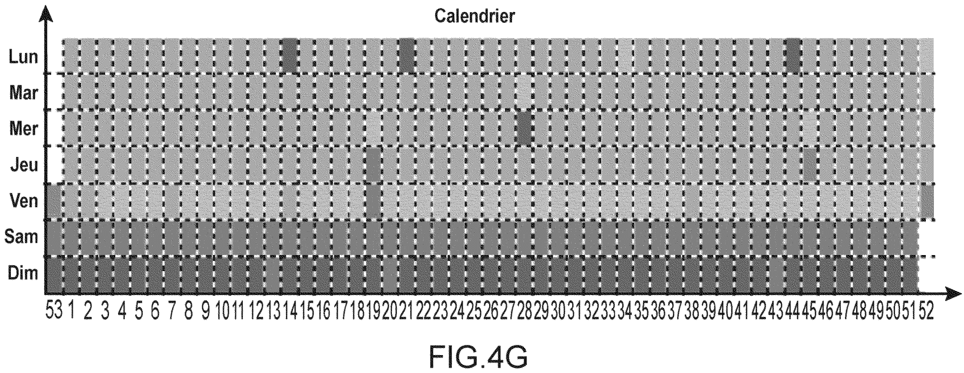

Le tableau de bord peut comporter d'autres fenêtres telles qu'illustrées par exemple sur les figures 4E, 4F, 4G donnant des vues complémentaires, sous forme respectivement d'un histogramme mensuel, d'un histogramme des jours de la semaine, et d'un calendrier sur lesquels les données projetées sont représentées d'une manière identifiable par l'utilisateur et permettant de faire la correspondance avec les groupes 401, 402, 403, 404 de la fenêtre de la figure 4A.

Dans l'exemple des figures 4E-4G, cette correspondance peut être établie par l'utilisateur à l'aide de teintes différentes (ici des niveaux de gris) reprenant celles utilisées dans la fenêtre de la figure 4A.

Les fenêtres des figures 4F et 4G donnent à l'utilisateur une information supplémentaire par rapport aux fenêtres des figures 4A et 4B. Par exemple, elles indiquent que les données du deuxième groupe 402 et qui ont été identifiées comme « jour fermés » correspondent essentiellement à des données prélevées sur le site un samedi.

Une synthèse graphique comportant une ou plusieurs des fenêtres décrites précédemment pour un ou plusieurs groupes peut être ensuite intégrée dans un rapport.

Une sauvegarde sous forme de fichiers de type projet peut être également réalisée.

Les résultats des traitement qui ont été décrits précédemment peuvent être éventuellement exportés sous forme de tableaux, par exemple dans des tableaux de fichiers Excel que l'outil 31 est configuré pour générer.

L'interface graphique de l'outil logiciel peut être mise en oeuvre de sorte qu'outre la première fenêtre de la figure 4A, d'autres fenêtres parmi celles décrites précédemment permettent de créer ou d'éditer des groupes de tronçons de données.

Des outils de sélections récursifs peuvent également permettre dans le tableau de bord décrit précédemment de passer d'un groupe sélectionné de tronçons à un sous-groupe de ce groupe sélectionné.

Après l'établissement de groupes de tronçons de données, une phase d'établissement de modèles numériques caractérisant chaque groupe de tronçons est ensuite mise en oeuvre.

La construction du modèle individuel caractéristique d'un groupe particulier peut être réalisée à l'aide d'un algorithme d'apprentissage dans lequel on vérifie pour chaque nouveau tronçon de données son appartenance à ce groupe particulier ou si ce tronçon est différent de tout ce qui a été vu précédemment.

Pour cela, on peut effectuer notamment une analyse de profil(s) temporel(s) d'évolution de signaux de mesures issus du dispositif de mesure et qui sont contenus dans ce nouveau tronçon.

Un exemple de profil temporel donne une consommation électrique pour la durée d'un tronçon, par exemple une consommation électrique journalière lorsqu'on réalise des tronçons de durée égale à un jour.

L'algorithme d'apprentissage du modèle individuel caractéristique peut être par exemple de type kernel à analyse en composantes principales (également appelé « KernelPCA »). Un algorithme de type machine à vecteur de support pour une classe (en anglais « one class Support Vector Machine » ou one-class SVM) peut être également utilisé. Ce type d'algorithme comprend un apprentissage d'une fonction de décision pour une détection de nouveauté. L'algorithme d'apprentissage peut également être de type Optimisation par Minimisation Séquentielle (SMO pour « Sequential Minimal Optimization »).

Une sélection d'algorithme d'apprentissage du modèle individuel caractéristique peut être réalisée par l'utilisateur U à l'aide d'une fenêtre de commande de l'interface graphique. Une fois établi, le modèle individuel caractéristique d'un groupe peut être sauvegardé.

Outre le modèle individuel caractéristique d'un groupe, un modèle de régression est mis en oeuvre.

Le modèle de régression est apte à établir une prédiction de données d'un élément du dispositif de mesure 10, par exemple un ou plusieurs capteur(s) ou un ou plusieurs compteur(s)), à partir de données issues d'un ou plusieurs autres éléments (capteur(s) ou compteur(s)).

Pour établir ce modèle de régression, l'utilisateur peut choisir un deuxième type d'algorithme d'apprentissage parmi plusieurs algorithmes d'apprentissage. Un algorithme de type à régression d'arête (« Ridge Régression » selon la terminologie anglo-saxonne) sur modèle polynomial, ou de régression Lasso sur modèle polynomial, ou de type machine à vecteur de pertinence RVM (acronyme de « relevance vector machine ») peut être utilisé. La sélection d'algorithme d'apprentissage du modèle de régression peut être également réalisée par l'utilisateur U à l'aide d'une fenêtre de commande de l'interface graphique.

L'outil 31 est en outre configuré pour former pour un groupe de données projetées, un autre type de modèle numérique individuel appelé modèle individuel calendaire. Ce modèle peut utiliser l'arbre de décision d'aide au nommage évoqué ci-dessus pour permettre de déterminer à quel groupe de tronçons de données un tronçon particulier appartient en recevant une indication temporelle associée à ce tronçon de données particulier. Un modèle numérique individuel calendaire donne une condition d'appartenance de nouvelles données au premier groupe à partir de métadonnées temporelles associées auxdites nouvelles données.

Ainsi à l'aide d'un tel modèle calendaire un groupe nommé « jours fermés » peut être modélisé par exemple par des tronçons correspondant à « l'ensemble des dimanches ET les jours fériés français SAUF pâques ».

Un système informatique 50 de suivi de performances de sites tel qu'évoqué précédemment en liaison avec la figure 1 collecte de manière régulière, par exemple tous les jours, des données issues du dispositif 10 de mesure, pour les présenter à un utilisateur sous forme par exemple de tableaux de bord, de tableaux d'alarmes, d'indicateurs de suivi, en particulier d'indicateurs clefs de performance (en anglais « Key Performance Indicators » ou KPI).

Un tel système 50 de suivi de performances peut utiliser un ou plusieurs des modèles décrits précédemment pour permettre d'évaluer par exemple d'éventuels gains énergétiques réalisés sur le site étudié ou de détecter une éventuelle dérive de consommation énergétique d'un site.

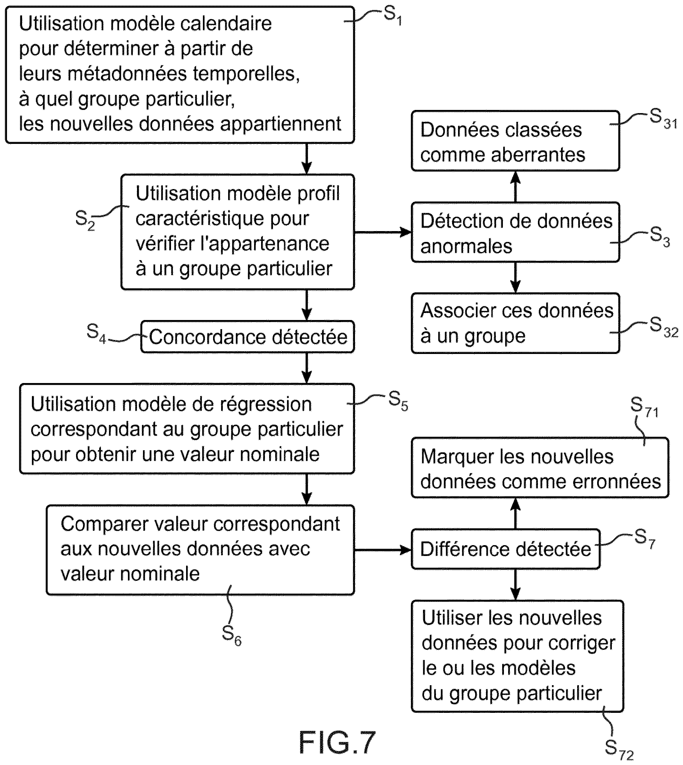

Un exemple de traitement effectué par le système 50 de suivi lorsqu'il reçoit de nouvelles données va à présent être décrit en liaison avec la figure 7.

Lorsque de nouvelles données sont reçues par le système 50 de suivi, celui-ci utilise le modèle calendaire pour permettre de déterminer, à partir des métadonnées temporelles associées à ces nouvelles données, à quel groupe particulier ces nouvelles données correspondent (étape S1).

Puis, le système 50 utilise le modèle profil caractéristique de ce groupe particulier pour vérifier l'appartenance de ces nouvelles données au groupe particulier (étape S2).

Dans ce cas, soit on détecte une appartenance des nouvelles données au groupes de données particulier soit les nouvelles données sont classées comme « anormales » (étape S3).

Dans ce cas, un utilisateur du système de suivi de performances décide de classer ces nouvelles données anormales comme données aberrantes (étape S31).

Dans le cas où une concordance existe (étape S4) et que l'appartenance des nouvelles données au groupes de données particulier est détecté à la fois à l'aide du modèle calendaire et du modèle individuel caractéristique, un modèle de régression associé à ce groupe est utilisé afin de pouvoir effectuer un suivi de performance énergétique (étape S5).

Par exemple, on peut détecter par le biais du modèle calendaire que de nouvelles données correspondent à un groupe de tronçons de données nommé « jours ouvrés » et vérifier par le biais du modèle individuel caractéristique que le profil de données de mesures associé à ou contenu dans ces nouvelles donnés correspond à un profil caractéristique de mesures effectuées lors de jours ouvrés.

Dans ce cas, on utilise ensuite un modèle de régression correspondant pour obtenir une valeur de consommation électrique nominale (étape S5), par exemple de E = 12 kWh d'un jour ouvré et pouvoir effectuer une comparaison à cette valeur nominale (étape S6).

Une différence significative avec la valeur nominale, par exemple détectée à l'aide d'un seuil de détection en valeur absolue ou relative (étape S7), est ensuite interprétée comme une erreur (étape S71).

Un tel système peut permettre de suivre l'effet d'une amélioration qui est apportée sur le site afin de réduire sa consommation énergétique ou de suivre une déviation non prévue qui mérite d'être signalée.

## Revendications

1. Procédé de détection d'anomalies de consommation énergétique d'un site à partir de données de mesures, les données de mesure comprenant des données de mesures de consommation électrique ainsi que des données de mesures d'un ou plusieurs paramètres physiques, issues d'au moins un dispositif de mesure (10) disposé sur ce site, le procédé comprenant des étapes consistant à, par le biais d'un système de traitement informatique :
a) sélectionner, dans un plage temporelle d'analyse choisie, des séries temporelles de données issues du dispositif de mesure, les séries temporelles de données étant associées à des métadonnées explicatives desdites séries temporelles de données,
b) segmenter les séries temporelles de données en une pluralité de tronçons de données d'une même durée, correspondant aux jours de fonctionnement dudit au moins un site dont les jours ouvrables, les jours fermés, les jours de démarrage et les jours de fonctionnement partiel,
c) effectuer une projection des tronçons de données sélectionnés et situés dans cette plage temporelle d'analyse dans un espace à au moins deux dimensions en fonction de leur degré de similarité,
d) afficher dans une interface graphique logicielle par le biais d'un dispositif d'affichage relié au système de traitement informatique, une représentation graphique dudit espace comportant des projections des tronçons de données, certaines projections étant regroupées sous forme d'un ou plusieurs groupes de tronçons de données, de sorte que les tronçons de données soient regroupés en fonction du type de jour de fonctionnement dudit au moins un site,
- sélectionner par un utilisateur de ladite interface graphique logicielle des tronçons particuliers situés à une distance donnée desdits groupes de données constituant des valeurs aberrantes à éliminer,
- suppression desdites valeurs aberrantes par l'utilisateur à l'aide d'un outil graphique de sélection de ladite interface logicielle, puis
e) sélectionner au moins un premier groupe de tronçons de données,
f) établir un ou plusieurs modèle numériques caractérisant le premier groupe de tronçons de données sélectionné, et de sorte que le ou les plusieurs modèle numérique caractérisent un comportement énergétique de l'au moins un site dans la plage temporelle d'analyse choisie, dans lequel parmi lesdits modèles établis à l'étape f) figure un modèle numérique individuel caractéristique du premier groupe construit à partir d'une analyse de profils temporels de mesure contenus dans les tronçons de données d'un desdits groupes, et un modèle numérique individuel calendaire donnant une condition d'appartenance de nouvelles données au premier groupe à partir de métadonnées temporelles associées auxdites nouvelles données,
le procédé comprenant en outre, après l'étape f), des étapes consistant à :
- recevoir de nouvelles données,
- détecter à l'aide dudit modèle calendaire, à partir des métadonnées temporelles associées à ces nouvelles données, si ces nouvelles données appartiennent à un groupe particulier parmi lesdits groupes,
- vérifier l'appartenance de ces nouvelles données au groupe particulier à l'aide dudit modèle individuel caractéristique associé au groupe particulier,
- utilisation d'un modèle de régression correspondant au groupe particulier pour obtenir une valeur de consommation énergétique nominale,
- comparer la valeur de consommation nominale aux nouvelles données, pour détecter une erreur en cas d'écart avec la valeur nominale.

2. Procédé selon l'une des revendications 1, dans lequel le dispositif de mesure (10) est doté d'un ou plusieurs éléments de mesure(s) dont au moins un compteur (11) de consommation électrique et/ou un ou plusieurs capteurs (13) de mesure de grandeurs physique(s), le procédé comprenant en outre l'établissement du modèle de régression apte à fournir une estimation des données de mesures d'au moins un élément sélectionné du dispositif de mesure à partir de données issues d'un ou plusieurs autres éléments de mesure(s) dudit dispositif de mesure.

3. Procédé selon l'une des revendications 1 ou 2, comprenant des étapes consistant à :
- établir pour le premier groupe un profil type de grandeur(s) mesurée(s) par le dispositif de mesure (10) pour une durée correspondant à celle des tronçons,
- afficher ce profil type par le biais de l'interface graphique.

4. Procédé selon l'une des revendications 1 à 3, comprenant en outre des étapes consistant à :
- sélectionner, par le biais de l'interface graphique logicielle, un groupe particulier de tronçons de données,
- associer ce groupe particulier à un identifiant.

5. Procédé selon la revendication 4, dans lequel l'identifiant est produit à l'aide d'un algorithme de nommage implémentant un arbre de décision et utilisant des métadonnées associées aux tronçons de données du groupe particulier.

6. Procédé selon l'une des revendications 1 à 5, dans lequel la sélection des séries temporelles de données à l'étape a) comprend une sélection d'au moins un type de métadonnée, en particulier :
- d'un descripteur de zone du site pour sélectionner des séries temporelles de données de mesures issues d'une ou plusieurs zones particulières du site parmi un ensemble de zones du site,
- et/ou d'un descripteur de type de dispositif de mesure pour sélectionner des séries temporelles de données issues d'un ou plusieurs types de moyens de mesure particuliers parmi un ensemble de moyens de mesures du dispositif de mesure,
- et/ou d'un descripteur de type de paramètre de mesure du site pour sélectionner des séries temporelles de données relatives à un ou plusieurs types de paramètres physiques parmi un ensemble paramètres physiques que le dispositif de mesure est susceptible de mesurer.

7. Procédé selon l'une des revendications 1 à 6 dans lequel dans ladite représentation graphique est située dans une première fenêtre de l'interface graphique logicielle et dans lequel les tronçons sont en outre représentés sous une forme d'une autre représentation graphique dans une deuxième fenêtre de l'interface graphique, la sélection du premier groupe dans ladite première fenêtre entrainant une sélection et une mise en évidence dans ladite deuxième fenêtre des tronçons du premier groupe.

8. Procédé selon la revendication 7, dans lequel la sélection des séries temporelles de données effectuée à l'étape a) ou la sélection du premier groupe effectuée à l'étape e), est réalisée par le biais de cette autre représentation graphique.

9. Procédé selon l'une des revendications 1 à 8, dans lequel le degré de similarité à l'étape b) est établi à l'aide d'une métrique, la métrique étant sélectionnée par le biais de l'interface graphique logicielle parmi une liste de plusieurs métriques différentes.

10. Programme d'ordinateur comprenant des instructions de code de programme pour permettre au système de traitements informatique d'exécuter une ou plusieurs des étapes du procédé suivant l'une quelconque des revendications 1 à 9

11. Support de données numérique utilisable par des moyens de traitements informatiques, comprenant des instructions de code d'un programme d'ordinateur selon la revendication 10.

## Patentansprüche

1. Verfahren zum Detektieren von Anomalien des Energieverbrauchs eines Standorts anhand von Messdaten, wobei die Messdaten Messdaten des Stromverbrauchs sowie Messdaten eines oder mehrerer physikalischer Parameter umfassen, die von mindestens einer am Standort angeordneten Messvorrichtung (10) stammen, wobei das Verfahren, das mittels eines Computerverarbeitungssystems durchgeführt wird, die folgenden Schritte umfasst:
a) Auswählen von Zeitreihen von Daten, die von der Messvorrichtung stammen, innerhalb eines ausgewählten Analysezeitbereichs, wobei die Zeitreihen von Daten mit Metadaten verknüpft sind, die die Zeitreihen von Daten erklären,
b) Segmentieren der Zeitreihen von Daten in eine Vielzahl von Datensegmenten mit gleicher Dauer, die den Betriebstagen des mindestens einen Standorts entsprechen, darunter Werktage, Feiertage, Starttage und Tage des Teilbetriebs,
c) Ausführen einer Projektion der ausgewählten Datensegmente, die sich in diesem Analysezeitbereich befinden, in einen mindestens zweidimensionalen Raum in Abhängigkeit von ihrem Ähnlichkeitsgrad,
d) Anzeigen einer grafischen Darstellung des Raums, die Projektionen der Datensegmente enthält, in einer grafischen Benutzeroberfläche einer Software mittels einer mit dem Computerverarbeitungssystem verbundenen Anzeigevorrichtung, wobei bestimmte Projektionen in Form einer oder mehrerer Gruppen von Datensegmenten gruppiert werden, so dass die Datensegmente in Abhängigkeit von der Betriebstagesart des mindestens einen Standorts gruppiert werden,
- Auswählen von bestimmten Segmenten, die sich in einer gegebenen Entfernung von den Datengruppen befinden, die die zu eliminierenden Ausreißer darstellen, durch einen Benutzer der grafischen Benutzeroberfläche der Software,
- Löschen der Ausreißer durch den Benutzer mit Hilfe eines grafischen Auswahl-Tools der Benutzeroberfläche der Software, dann
e) Auswählen mindestens einer ersten Gruppe von Datensegmenten,
f) Erstellen eines oder mehrerer digitaler Modelle, die die erste ausgewählte Gruppe von Datensegmenten charakterisieren, und derart, dass das oder die mehreren digitalen Modelle ein energetisches Verhalten des mindestens einen Standorts innerhalb des gewählten Analysezeitbereichs charakterisieren, wobei unter den in Schritt f) erstellten Modellen ein individuelles digitales Modell, das für die erste Gruppe charakteristisch ist und aus einer Analyse von zeitlichen Messprofilen konstruiert wurde, die in den Datensegmenten einer der Gruppen enthalten sind, und ein individuelles digitales Kalendermodell enthalten ist, das aus zeitlichen Metadaten, die mit den neuen Daten verknüpft sind, eine Bedingung für die Zugehörigkeit neuer Daten zur ersten Gruppe anhand von zeitlichen Metadaten, die mit den neuen Daten verknüpft sind, liefert,
wobei das Verfahren ferner nach Schritt f) die folgenden Schritte umfasst:
- Empfangen neuer Daten,
- Detektieren mit Hilfe des Kalendermodells anhand der mit den neuen Daten verknüpften zeitlichen Metadaten, ob die neuen Daten zu einer bestimmten Gruppe unter den Gruppen gehören,
- Überprüfen der Zugehörigkeit der neuen Daten zu der bestimmten Gruppe mit Hilfe des charakteristischen individuellen Modells, das mit der bestimmten Gruppe verknüpft ist,
- Verwenden eines der bestimmten Gruppe entsprechenden Regressionsmodells, um einen nominalen Energieverbrauchswert zu erhalten,
- Vergleichen des nominalen Verbrauchswerts mit den neuen Daten, um im Falle einer Abweichung vom nominalen Wert einen Fehler zu detektieren.

2. Verfahren nach einem der Ansprüche 1, wobei die Messvorrichtung (10) mit einem oder mehreren Messelementen einschließlich mindestens eines Stromverbrauchszählers (11) und/oder eines oder mehrerer Sensoren (13) zur Messung physikalischer Größen ausgestattet ist, wobei das Verfahren ferner das Erstellen des Regressionsmodells umfasst, das dazu geeignet ist, eine Schätzung der Messdaten mindestens eines ausgewählten Elements der Messvorrichtung anhand von Daten bereitzustellen, die von einem oder mehreren anderen Messelementen der Messvorrichtung stammen.

3. Verfahren nach einem der Ansprüche 1 oder 2, das ferner die folgenden Schritte umfasst:
- Erstellen eines Standardprofils der von der Messvorrichtung (10) gemessenen Größe(n) für die erste Gruppe für eine Dauer, die der der Segmente entspricht,
- Anzeigen des Standardprofils mittels der grafischen Benutzeroberfläche.

4. Verfahren nach einem der Ansprüche 1 bis 3, das ferner die folgenden Schritte umfasst:
- Auswählen einer bestimmten Gruppe von Datensegmenten mittels der grafischen Benutzeroberfläche der Software,
- Zuordnen der bestimmten Gruppe zu einer Kennung.

5. Verfahren nach Anspruch 4, wobei die Kennung mit Hilfe eines Benennungsalgorithmus erzeugt wird, der einen Entscheidungsbaum implementiert und Metadaten verwendet, die mit den Datensegmenten der bestimmten Gruppe verknüpft sind.

6. Verfahren nach einem der Ansprüche 1 bis 5, wobei das Auswählen der Zeitreihen von Daten in Schritt a) das Auswählen mindestens einer Art von Metadaten umfasst, insbesondere:
- eines Standortzonendeskriptors, um Zeitreihen von Messdaten auszuwählen, die aus einer oder mehreren bestimmten Zonen des Standorts aus einer Reihe von Zonen des Standorts stammen,
- und/oder eines Deskriptors der Messvorrichtungsart, um Zeitreihen von Daten auszuwählen, die von einer oder mehreren Arten bestimmter Messmitteln aus einer Reihe von Messmitteln der Messvorrichtung stammen,
- und/oder eines Deskriptors der Messparameterart des Standorts, um Zeitreihen von Daten auszuwählen, die sich auf eine oder mehrere Arten von physikalischen Parametern aus einer Reihe von physikalischen Parametern beziehen, die die Messvorrichtung messen kann.

7. Verfahren nach einem der Ansprüche 1 bis 6, wobei sich die grafische Darstellung in einem ersten Fenster der grafischen Benutzeroberfläche der Software befindet, und wobei die Segmente ferner in Form einer anderen grafischen Darstellung in einem zweiten Fenster der grafischen Benutzeroberfläche dargestellt werden, wobei das Auswählen der ersten Gruppe im ersten Fenster zum Auswählen und Hervorheben der Segmente der ersten Gruppe im zweiten Fenster führt.

8. Verfahren nach Anspruch 7, wobei das in Schritt a) erfolgte Auswählen der Zeitreihen von Daten oder das in Schritt e) erfolgte Auswählen der ersten Gruppe mittels der anderen grafischen Darstellung durchgeführt wird.

9. Verfahren nach einem der Ansprüche 1 bis 8, wobei der Ähnlichkeitsgrad in Schritt b) mit Hilfe einer Metrik festgelegt wird, wobei die Metrik mittels der grafischen Benutzeroberfläche der Software aus einer Liste mit mehreren unterschiedlichen Metriken ausgewählt wird.

10. Computerprogramm, das Programmcodeanweisungen umfasst, um dem Computerverarbeitungssystem zu ermöglichen, einen oder mehrere der Schritte des Verfahrens nach einem der Ansprüche 1 bis 9 auszuführen.

11. Digitaler Datenträger, der von Computerverarbeitungsmitteln verwendet werden kann, die Codeanweisungen eines Computerprogramms nach Anspruch 10 umfassen.

## Claims

1. A method for detecting energy consumption anomalies of a site based on measurement data, the measurement data comprising electrical consumption measurement data as well as measurement data of one or more physical parameter(s), derived from at least one measuring device (10) located on this site, the method comprising steps consisting, using a computer processing system, in:
a) selecting, within a selected analysis time range, time series of data derived from the measuring device, the data time series being associated with metadata explaining said data time series,
b) segmenting the data time series into a plurality of data segments of the same duration, corresponding to the operational days of said at least one site including working days, closed days, start-up days, and partial operational days,
c) performing a projection of the selected data segments located within this analysis time range in a space having at least two dimensions according to their degree of similarity,
d) displaying in a software graphical interface, using a display device connected to the computer processing system, a graphical representation of said space including projections of the data segments, some projections being grouped together in the form of one or more group(s) of data segments, so that the data segments grouped together according to the type of operational day of said at least one site,
- selecting, by a user of said software graphical interface, particular segments located at a given distance from said groups of data forming aberrant data to be eliminated,
- deleting said aberrant values by the user using a selection graphical tool of said graphical interface, then
e) selecting at least one first group of data segments,
f) establishing one or more digital model(s) characterizing the selected first group of data segments, and so that the digital model(s) characterize(s) an energy behavior of the at least one site within the selected analysis time range, wherein, among said models established in step f), there are an individual digital model characteristic of the first group constructed based on an analysis of measurement time profiles contained in the data segments of one of said groups, and a calendar individual digital model giving a condition of belonging of new data to the first group based on time metadata associated with said new data,
the method further comprising, after step f), steps of:
- receiving new data,
- detecting, using said calendar model, based on the time metadata associated with these new data, whether these new data belong to a particular group among said groups,
- verifying whether these new data belong to the particular group using said characteristic individual model associated with the particular group,
- using a regression model corresponding to the particular group to obtain a nominal energy consumption value,
- comparing the nominal consumption value with the new data, to detect an error in case of discrepancy with the nominal value.

2. The method according to claim 1, wherein the measuring device (10) is provided with one or more measuring element(s) including at least one electrical consumption meter (11) and/or one or more sensors (13) for measuring physical quantit(y/ies), the method further comprising establishing the regression model able to provide an estimate of the measurement data of at least one selected element of the measuring device based on data derived from one or more other measuring elements(s) of the measuring device.

3. The method according to one of claims 1 or 2, comprising steps of:
- establishing for the first group a standard profile of quantit(y/ies) measured by the measuring device (10) for a duration corresponding to that of the segments,
- displaying this standard profile using the graphical interface.

4. The method according to one of claims 1 to 3, further comprising steps of:
- selecting, using the software graphical interface, a particular group of data segments,
- associating this particular group with an identifier.

5. The method according to claim 4, wherein the identifier is produced using a naming algorithm implementing a decision tree and using metadata associated with the data segments of the particular group.

6. The method according to one of claims 1 to 5, wherein the selection of the data time series in step a) comprises selecting at least one type of metadata, in particular:
- of a zone descriptor of the site to select time series of measurement data derived from one or more particular zone(s) of the site among a set of zones in the site,
- and/or of a measuring device type descriptor to select time series of data derived from one or more type(s) of particular measuring means among a set of measuring means of the measuring device,
- and/or of a measuring parameter type descriptor of the site to select time series of data relating to one or more type(s) of physical parameters among a set of physical parameters that the measuring device could measure.

7. The method according to one of claims 1 to 6, wherein said graphical representation is located in a first window of the software graphical interface and wherein the segments are further represented in a form of another graphical representation in a second window of the graphical interface, the selection of the first group in said first window resulting in selecting and highlighting the segments of the first group in said second window.

8. The method according to claim 7, wherein the selection of the data time series performed in step a), or the selection of the first group performed in step e), is carried out using this other graphical representation.

9. The method according to one of claims 1 to 8, wherein the degree of similarity in step b) is established using a metric, the metric being selected using the software graphical interface among a list of several different metrics.

10. A computer program comprising program code instructions to enable the computer processing system to execute one or more of the steps of the method according to any one of claims 1 to 9.

11. A digital data medium which can be used by computer processing means, comprising code instructions of a computer program according to claim 10.
